# EUROPÄISCHE PATENTSCHRIFT

(11) **EP 0 541 571 B1**
(45) Veröffentlichungstag und Bekanntmachung des Hinweises auf die Patenterteilung: **05.10.1994**
(21) Anmeldenummer: 91911963.6
(22) Anmeldetag: 02.07.1991
(51) Int. Cl.: H01L 21/00

(54) **VORRICHTUNG ZUM EINSEITIGEN ÄTZEN EINER HALBLEITERSCHEIBE**
DEVICE FOR ONE-SIDEDLY ETCHING A SEMICONDUCTOR SLICE
DISPOSITIF DE GRAVURE D'UNE SEULE FACE D'UNE TRANCHE SEMI-CONDUCTRICE

(30) Priorität: 02.08.1990 DE 4024576
(43) Veröffentlichungstag der Anmeldung: 19.05.1993
(73) Patentinhaber: ROBERT BOSCH GMBH, 70442 Stuttgart (DE)
(72) Erfinder: KUMMER, Nils, D-7140 Ludwigsburg (DE); MAREK, Jiri, D-7410 Reutlingen (DE); WILLMANN, Martin, D-7410 Reutlingen (DE); FINDLER, Günther, D-7000 Stuttgart 80 (DE)
(86) Internationale Anmeldenummer: DE9100545
(87) Internationale Veröffentlichungsnummer: WO9202948

(56) Entgegenhaltungen:
- SOVIET INVENTIONS ILLUSTRATED SECTION EL, Week 8718, 17 June 1987, Derwent Publications Ltd., London, GB, CLASS U, page 5, no. 87-128378/18; & SU-A-1257730
- JOURNAL OF VACUUM SCIENCE & TECHNOLOGY B, vol. 3, no. 4, August 1985, pages 1015-1024; G. Kaminsky: "Micromachining of silicon mechanical structures"

## Beschreibung

### Stand der Technik

Die Erfindung betrifft eine Vorrichtung zum einseitigen Ätzen von Halbleiterscheiben (Siliciumwafern), welche nach Art einer Ätzdose aufgebaut ist. Eine solche ist bekannt aus der Zeitschrift Vacuum Science Technology, Ausgabe Juli/August 1985, Seiten 1015 ff., G. Kaminsky, "Mikromachining of silicon mechanical structures". Darin wird eine Ätzhalterung für Siliciumwafer in Form einer Teflonplatte beschrieben, an deren Rand in einer Nut ein O-Ring angeordnet ist, auf dem der zu ätzende Wafer gelagert wird. Der Wafer wird durch einen Ring aus Teflon, welcher mittels Nylonschrauben mit der Grundplatte verbunden wird, auf der Teflonplatte befestigt. Durch den Teflon-Ring gelangt Ätzlösung an die Oberfläche des Wafers. Der O-Ring verhindert, daß Ätzlösung an die Rückseite gelangt. Die Ätzlösung kann allerdings den Rand des Wafers bis zur Kontaktzone zwischen Wafer und O-Ring beidseitig benetzen. Die mechanische Stabilität ist deshalb im Randbereich des Wafers vermindert, außerdem werden Bearbeitungsmöglichkeiten des Wafers nach dem Ätzprozeß eingeschränkt. Während des Ätzvorgangs steigt infolge der hohen Ätztemperaturen der Druck der unter dem Wafer befindlichen Luft an. Dadurch erhöht sich, besonders am Randbereich des Wafers, wo er auf dem O-Ring aufliegt, die Bruchgefahr. Eine Vorrichtung zum Druckausgleich für den unter dem Wafer entstehenden Luftraum ist nicht vorgesehen. Auch die Möglichkeit einer elektrischen Kontaktierung des Wafers, um einen elektrochemischen Ätzstop durchführen zu können, ist nicht vorgesehen.

Das Grundmaterial Teflon weist ferner eine für die vorgesehene Anwendung bei hohen Ätztemperaturen zu geringe Formstabilität auf. In Lösungen-verändert Teflon durch Quellen sein Volumen und damit seine Form. Eine Ätzhalterung aus Teflon kann deshalb nicht mehrfach benutzt werden.

Der Erfindung liegt die Aufgabe zugrunde, eine Vorrichtung für das einseitige Ätzen von Siliciumwafern anzugeben, die den zu ätzenden Wafer mechanisch gering beansprucht, einen vollständigen Schutz der Waferkanten gewährleistet und einen elektrochemischen Ätzstop gestattet.

Die Aufgabe wird erfindungsgemäß gelöst durch die kennzeichnenden Merkmale des Anspruchs 1. Hierbei wird eine Halterung nach Art einer Ätzdose mit offenem Oberteil benutzt, die mit zwei O-Ringen versehen ist, zwischen welche der Wafer eingespannt wird und welche so angeordnet sind, daß die Ätzlösung nur den innerhalb des deckelseitigen O-Rings befindlichen Innenbereich der zu ätzenden Waferseite erreichen kann. Der unter der Waferrückseite entstehende Hohlraum ist über eine Bohrung, der sich ein Rohr oder ein Schlauch anschließt, mit der Außenumgebung verbunden. Die Entstehung eines Überdruckes unter dem Wafer ist dadurch ausgeschlossen. Durch die Bohrung wird gleichzeitig die Zuleitung geführt für die zum elektrochemischen Ätzstop erforderliche elektrische Kontaktierung des Wafers.

### Vorteile der Erfindung

Die erfindungsgemäße Vorrichtung hat den Vorteil, daß die Waferkante absolut sicher gegen Kontakt mit der Ätzlösung geschützt ist. Die den Wafer haltenden O-Ringe sind genau übereinander angeordnet, so daß beide Waferseiten mit symmetrischen Haltekräften beaufschlagt werden. Der Wafer ist dadurch, daß seine Befestigung nur über O-Ringe erfolgt, elastisch gelagert. Er wird gegen die Ätzlösung geschützt von der Rückseite her elektrisch kontaktiert. Durch die Verbindung mit der Außenumgebung entsteht auch bei hohen Temperaturen der Ätzlösung im Hohlraum unter der Waferrückseite kein Überdruck. Die Vorrichtung gestattet damit eine maximale Bruchsicherheit. Die gute Formstabilität der vorgeschlagenen Materialien gestattet eine Mehrfachverwendung der Ätzdose. Die elektrische Kontaktierung des Wafers erfolgt vorteilhaft durch Federkontakte.

Weitere vorteilhafte Weiterbildungen der Vorrichtung ergeben sich aus den in den Unteransprüchen genannten Maßnahmen.

Bei Herstellung der Ätzdose aus einem Polyvinyliden Fluorid-(PVDF)-Kunststoff werden zweckmäßig in Deckel und Bodenteil jeweils Nuten vorgesehen, welche die O-Ringe fixieren. Das Volumen der Nuten wird, da die O-Ringe durch den Kontakt mit der Ätzlösung quellen, so bemessen, daß der Druck auf den Wafer konstant bleibt. Im Kontaktbereich zwischen Deckel und Bodenteil ist zweckmäßig ein dritter O-Ring vorgesehen, um zusätzliche Sicherheit zu erhalten, daß keine Ätzlösung in den Kantenbereich eindringen kann. Vorteilhaft wird für die elektrische Kontaktierung der Waferrückseite ein Federstift verwendet.

In einer anderen vorteilhaften Ausführung wird die Ätzdose von einer im Handel erhältlichen Polypropylen-(PP)-Transportbox abgeleitet. Eine auf diese Art gefertigte Ätzdose ist milchig durchsichtig und gestattet, etwaige Undichtheiten der Ätzdose sofort von außen zu erkennen. Eine solche aus PP bestehende Ätzdose ist ferner außerordentlich preisgünstig. In den Kontaktbereich zwischen Deckel und Bodenteil wird als zusätzliche Dichtung zweckmäßig Siliconpaste eingebracht. Ein Federteil im Grundkörper erlaubt eine zuverlässige elektrische Kontaktierung der Waferrückseite sowie ein schnelles Einsetzen und Entnehmen des Wafers.

Zwei Ausführungsbeispiele der Erfindung werden anhand von Zeichnungen und der anschließenden Beschreibung näher erläutert werden.

### Zeichnung

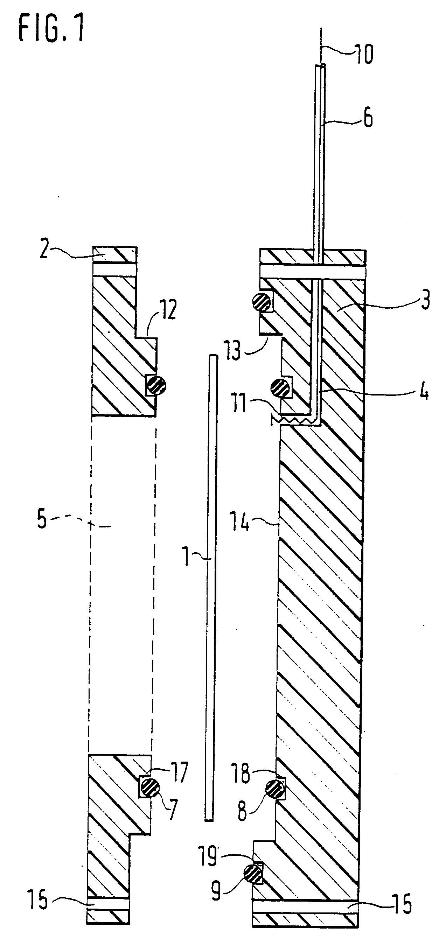

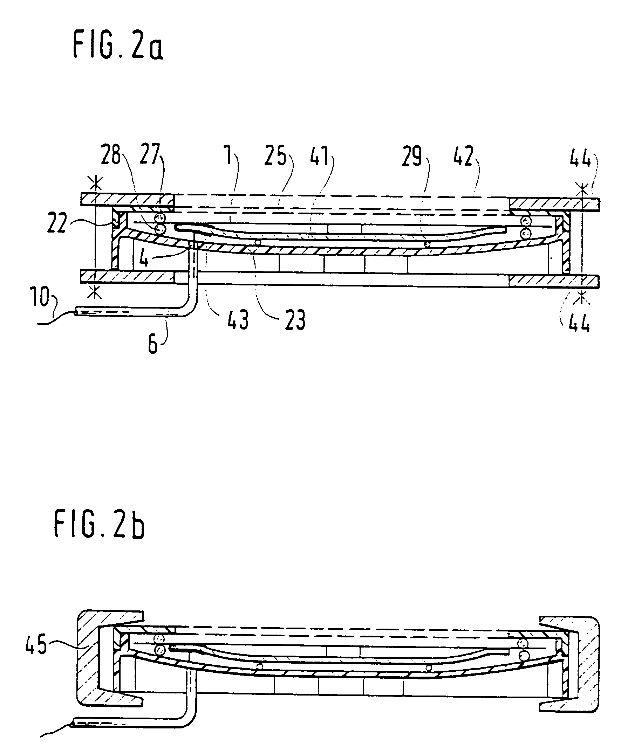

Es zeigen Figur 1 einen Schnitt einer aus PVDF gefertigten Ätzdose, Figur 2a und 2b Schnitte einer PP-Ätzdose.

### Beschreibung

Das in Figur 1 gezeigte erste Ausführungsbeispiel besteht aus den Hauptteilen Grundkörper 3 und Deckel 2. Beide Teile sind aus dem Kunststoff PVDF gefertigt. Das Material ist auch bei hohen Temperaturen formstabil und erlaubt eine Mehrfachverwendung der Ätzdose. Die gesamte, aus Deckel 2 und Grundkörper 3 gebildete Ätzdose hat vorzugsweise eine runde Form, jedoch sind auch andere Formen möglich. Deckel 2 und Grundkörper 3 sind in ihrer Form so gestaltet, daß sie aufeinander passen. Dazu ist der Rand des Deckels 2 gegenüber dem Innenbereich 12 stufenförmig abgesenkt, während der Rand des Grundkörpers 3 stufenförmig erhöht ist. Die Stufungen sind so gestaltet, daß bei geschlossener Ätzdose mit darin befindlichem Wafer die Randbereiche des Deckels 2 und des Grundkörpers 3 bündig aufeinanderliegen, wobei die O-Ringe 7, 8, zwischen welchen der Wafer 1 eingespannt ist, um etwa 20 % ihrer Schnurdicke gequetscht sind. Die Durchmesser der Vertiefung am Innenbereich 13 bzw. der Überhöhung am Innenbereich 12 sind etwas größer als der Durchmesser des Wafers 1, für den die Ätzdose ausgelegt ist. Der Grundkörper 3 besitzt vorzugsweise zwei konzentrische Nuten 18 und 19, von denen eine in den stufenförmig überhöhten Randbereich, die andere am Rand des Innenbereichs 13 eingearbeitet ist. In den Nuten 18, 19 befindet sich jeweils ein O-Ring 8, 9. Die innerhalb des inneren O-Ringes 8 liegende Grundkörperoberfläche 14 ist über eine Bohrung 4, deren Durchmesser zweckmäßig 0,1 - 5 mm beträgt, mit der Grundkörperaußenseite verbunden. Am Ausgang der Bohrung 4 auf der Grundkörperaußenseite schließt sich unmittelbar ein Röhrchen 6 oder ein Schlauch an, welche die Bohrung 4 fortsetzt. Durch die Bohrung 4 erfolgt zum einen der Druckausgleich zwischen der Umgebung und dem durch Wafer 1, O-Ring 8 und Grundkörperoberfläche 14 umschlossenen Raum. Zum anderen wird durch die Bohrung 4 der für die elektrische Kontaktierung des Wafers 1 erforderliche Draht 10 nach außen geführt. Die Bohrung 4 verläuft zweckmäßig rechtwinklig von der Innenfläche zur schmalen seitlichen Außenfläche des Grundkörpers. Durch die rechtwinklige Führung kann die Ätzdose bequem vertikal in die Ätzlösung eingeführt werden. Die Bohrung 4 ist zu diesem Zweck an ihrem Ausgang in Form eines sich anschließenden geraden Röhrchens 6 oder Schlauches fortgesetzt, welches aus der Ätzlösung herausragt. Andere Führungen der Bohrung 4 sind selbstverständlich gleichwertig. Auf der inneren Grundkörper-Oberfläche 14 ist am Ende des durch die Bohrung 4 geführten Drahtes 10 ein Federkontakt 11 angebracht, der eine sichere elektrische Kontaktierung des Wafers 1 gewährleistet.

Der Ätzdosendeckel 2 weist im gegenüber dem Rand überhöhten Innenbereich 12 eine Nut 17 auf, die so ausgebildet ist, daß sie bei geschlossener Ätzdose genau über der Innennut 18 des Grundkörpers liegt. In der Nut ist ein weiterer O-Ring 7 angeordnet.

Der äußere O-Ring 9 im Grundkörper 3 und der im Deckel 2 plazierte O-Ring 7 sind während des Ätzprozesses jeweils von einer Seite her der Ätzlösung ausgesetzt, wodurch sie geringfügig quellen. Dies kann zu einem erhöhten Druck auf den zwischen den O-Ringen 7 und 8 eingespannten Wafer führen. Die Form der die O-Ringe 7 bis 9 fixierenden Nuten 17 bis 19 ist deshalb zweckmäßig so gestaltet, daß eine Volumenvergrößerung der O-Ringe 7 bis 9 infolge Quellens von den Nuten 17 bis 19 aufgenommen und der Druck auf den Wafer 1 dadurch jederzeit etwa konstant bleibt.

Deckel 2 und Grundkörper 3 der Ätzdose werden durch Schrauben, welche durch dafür an den Rändern von Deckel und Grundkörper angeordnete Bohrungen 15 gesteckt werden, zusammengehalten. Alternativ kann die Verbindung von Deckel und Grundkörper auch durch Schnellspannverschlüsse erfolgen. In diesem Fall müssen an der Deckeloberseite und der Grundkörperunterseite Maßnahmen zur Fixierung der Schnellspannklammern getroffen werden. Der Druck, mit dem die Ätzdosenteile zusammengepreßt werden, ist so zu wählen, daß die gestuften Ränder von Deckel 2 und Grundkörper 3 fest aufeinander liegen, wobei die von außen sichtbaren O-Ringe 7 und 9 nahezu vollständig in die Nuten 17 bzw. 19 gepreßt werden.

Zur Anwendung der Ätzdose wird der Wafer 1 in den Grundkörper 3 auf den darin angeordneten inneren O-Ring 8 gelegt. Die zu schützende Seite weist zur Grundkörperoberfläche 14. Anschließend wird der Deckel 2 aufgelegt und durch Festziehen der Schrauben mit dem Grundkörper 3 verbunden. Die verschlossene Ätzdose kann in beliebiger Weise der Ätzlösung ausgesetzt werden. Insbesondere können Dauer und Temperatur des Ätzprozesses frei gewählt werden, da durch die Druckausgleichsbohrung 4 gewährleistet ist, daß in dem unter dem Wafer 1 gegebenen Hohlraum kein Überdruck, und somit keine Bruchgefahr entstehen kann.

Ein zweites Ausführungsbeispiel zeigen die Figuren 2a und 2b. Mit dem ersten Ausführungsbeispiel übereinstimmende Teile sind mit den gleichen Bezugszahlen versehen.

Das in Figur 2a gezeigte Ausführungsbeispiel besteht aus den Hauptteilen Deckel 22 und Grundkörper 23 sowie zwei Preßringen 44. Der Grundkörper 23 ist das Unterteil einer handelsüblichen Wafertransportbox, wie sie beispielsweise bei der Fa. FLUOROWARE erhältlich ist. Die Ätzdose besteht aus Polypropylen (PP), einem Material das auch bei hohen Ätztemperaturen eine gute Formstabilität aufweist und sehr preiswert ist. In der leicht konischen Bodenwanne des Grundkörpers 23 befinden sich ein zentrisch lose eingelegter O-Ring 28, dessen Durchmesser etwa 4/5 des Ätzdosendurchmessers beträgt, sowie ein innerhalb des O-Ringes 28 angeordnetes kreuzförmiges Federteil 41, wie es ebenfalls im Handel erhältlich ist. Eine der vier federnden Zungen 42 des Federteils 41 besteht entweder aus elektrisch leitfähigem Material, oder ist mit einem elektrisch leitenden Blech 43 einer Dicke von ungefähr 0,05 mm ummantelt. Das Blech ist vorzugsweise aus Platin. Das Federteil 41 stabilisiert einerseits bei geschlossener Ätzdose den zu ätzenden Wafer 1 im Mittelbereich, andererseits dient die blechummantelte Zunge 42 zur elektrischen Kontaktierung der Waferrückseite. Es kann fest mit dem Grundkörper 3 verbunden oder lose eingelegt sein. In letzterem Fall ist zweckmäßig eine Lagerung für das Federteil 41, zum Beispiel in Form eines Ringes vorgesehen. An das Metallblech 43 ist ein Draht 10 aus Platin angelötet, welcher durch eine in der Bodenwanne des Grundkörpers 23 plazierte Bohrung 4 aus dem Grundkörper herausgeführt ist. An die Bohrung 4 schließt sich an der Bodenwannen-Außenseite dichtschlüssig ein aus der Ätzlösung herausragendes Röhrchen 6, bzw. ein Schlauch o. dgl. an, in dem der Kontaktierdraht 10 aus der Ätzlösung herausgeführt wird. Der Deckel 22 leitet sich aus dem standardmäßig zum Grundkörper 23 gehörenden Oberteil der Transportbox ab. In die Oberseite ist eine kreisförmige Öffnung 25 gedreht, durch welche die Ätzlösung hindurchtreten kann. Ihr Durchmesser beträgt zweckmäßig 60 bis 70 % des gesamten Ätzdosendurchmessers, bei einer für Vier-Zoll-Wafer vorgesehenen Ätzdose beispielsweise 70 - 80 mm.

Zur Anwendung der Ätzdose wird der Wafer 1 mit der zu ätzenden Seite nach oben in den Grundkörper 23 auf den darin angeordneten O-Ring 28 gelegt. Durch das von der Unterseite leicht gegen die Waferrückseite drückende Federteil 41, welches beispielsweise ein Federkreuz ist, erfolgt die elektrische Kontaktierung des Wafers 1. Auf die nach oben weisende Waferseite wird ein zweiter O-Ring 27 gelegt, der konzentrisch ausgerichtet wird. Der zweite O-Ring 27 hat denselben Durchmesser wie der im Grundkörper 23 angeordnete. Die Querschnitte beider O-Ringe 27, 28 sind so dimensioniert, daß der zwischen den O-Ringen 27, 28 eingespannte Wafer 1 bei geschlossener Ätzdose fest und rutschsicher gelagert wird. Ein leichtes Quellen der O-Ringe 27, 28 ändert den Anpreßdruck auf den Wafer 1 nicht. Anschließend wird der Deckel 22 auf den Grundkörper 23 aufgesetzt, wobei zur Verbesserung der Dichtigkeit auf die Dichtfläche zwischen Deckel 22 und Grundkörper 23 pastöses Silicon aufgebracht wird. Eine andere Möglichkeit, eine gute Dichtung zu erzielen, besteht darin, die Dichtflächen zwischen Grundkörper 23 und Deckel 22 konisch zu gestalten, so daß sie durch Zusammenpressen schlüssig aufeinanderliegen.

Der äußere Zusammenhalt zwischen Deckel 22 und Grundkörper 23 der Ätzdose erfolgt, wie in Figur 2b dargestellt, durch Schnellspannverschlüsse 45 in Form von Klammerverschlüssen. Sie sind zweckmäßig mit einem der Preß-Ringe 44 fest verbunden und werden am anderen durch geeignete Vorrichtungen fixiert.

Alternativ wird die aus Deckel 22 und Grundkörper 23 bestehende Ätzdose durch zwei Preß-Ringe 44 aus einem säurebeständigen Material, wie z. B. hartem Kunststoff, zusammengehalten, indem sie zwischen die Ringe 44 eingespannt wird. Die Preß-Ringe 44 ihrerseits werden mittels Schrauben gegeneinander gepreßt. Die Preß-Ringe sind in diesem Fall mit Bohrungen versehen, durch welche die Schrauben gesteckt werden.

## Patentansprüche

1. Vorrichtung zum einseitigen Ätzen einer Halbleiterscheibe (Wafer), nach Art einer Ätzdose, gekennzeichnet durch einen wannenförmigen Grundkörper (3, 23), einen dichtschlüssig auf den Grundkörper (3, 23) passenden Deckel (2, 22), der oberseitig eine Öffnung (5, 25) zum Durchtritt der Ätzflüssigkeit aufweist, mindestens zwei übereinander angeordnete O-Ringe (7, 8, 27, 28), zwischen denen der zu ätzende Wafer (1) eingespannt wird, von denen einer (8, 28) konzentrisch im Grundkörper (3, 23) und der andere (7, 27) konzentrisch im Deckel (2, 22) angeordnet ist, und eine durch den Grundkörper (3, 23) verlaufende Bohrung (4) die die innerhalb des O-Ringes (8, 28) liegende Grundkörperoberfläche (14) mit der Grundkörperaußenseite verbindet und durch welche ein mit einem elektrischen Federkontakt (11) zur Kontaktierung des Wafers verbundener Draht (10) aus der Ätzdose herausgeführt wird.

2. Vorrichtung nach Anspruch 1, dadurch gekennzeichnet, daß wenigstens zwei O-Ringe (7, 8, 27, 28) gleiche Durchmesser haben.

3. Vorrichtung nach Anspruch 1, dadurch gekennzeichnet, daß sich am Ausgang der Bohrung (4) ein Röhrchen (6), ein Schlauch oder dgl. anschließt, welches die Bohrung fortsetzt und aus der Ätzlösung herausführt.

4. Vorrichtung nach Anspruch 3, dadurch gekennzeichnet, daß das Röhrchen (6) bzw. der Schlauch aus Polypropylen (PP) oder Polyviny-lidenfuorid (PVDF)-Kunststoff hergestellt sind.

5. Vorrichtung nach Anspruch 1, dadurch gekennzeichnet, daß Deckel (2) und Grundkörper (3) aus PVDF-Kunststoff hergestellt sind.

6. Vorrichtung nach einem der vorhergehenden Ansprüche, dadurch gekennzeichnet, daß der Innenbereich (12) der Deckelunterseite stufenförmig überhöht, der Innenbereich (13) der Grundkörperoberseite stufenförmig vertieft ausgebildet sind, und die Stufungen gleichen Durchmesser besitzen.

7. Vorrichtung nach einem der vorhergehenden Ansprüche, dadurch gekennzeichnet, daß Deckel (2) und Grundkörper (3) Nuten (17) bzw. (18) aufweisen, in denen die O-Ringe (7) bzw. (8) vorspringend angeordnet sind.

8. Vorrichtung nach einem der vorhergehenden Ansprüche, dadurch gekennzeichnet, daß der Grundkörper (3) auf dem gegenüber dem Innenbereich (13) überhöhten Rand eine weitere Nut (19) aufweist, in der ein weiterer O-Ring (9) angeordnet ist.

9. Vorrichtung nach einem der vorhergehenden Ansprüche, dadurch gekennzeichnet, daß der Deckel (2) im gegenüber dem Innenbereich (12) vertieften Rand eine weitere Nut aufweist, in der ein weiterer O-Ring (9) angeordnet ist.

10. Vorrichtung nach einem der vorhergehenden Ansprüche, dadurch gekennzeichnet, daß bei geschlossener Ätzdose die Randbereiche des Deckels (2) und des Grundkörpers (3) unter Ausübung eines definierten Anpreßdrucks auf die zwischen Deckel (2) und Grundkörper (3) befindlichen O-Ringe (7, 8, 9) bündig aufeinanderliegen.

11. Vorrichtung nach Anspruch 1, dadurch gekennzeichnet, daß der Federkontakt (11) als aus der Bohrung (4) herausragender Federstift ausgebildet ist.

12. Vorrichtung nach einem der vorhergehenden Ansprüche, dadurch gekennzeichnet, daß die Nuten (17) bis (19) so gestaltet sind, daß sie das sich infolge Quellens und/oder Pressung veränderte Volumen der O-Ringe (7) bis (9) aufnehmen können und die über die O-Ringe (7) bis (9) übertragenen Druckkräfte etwa konstant bleiben.

13. Vorrichtung nach Anspruch 1, dadurch gekennzeichnet, daß Deckel (22) und Grundkörper (23)der Ätzdose aus PP hergestellt sind.

14. Vorrichtung nach Anspruch 13, dadurch gekennzeichnet, daß der O-Ring (28) lose im Grundkörper (23) liegt.

15. Vorrichtung nach Anspruch 13, dadurch gekennzeichnet, daß der deckelseitige O-Ring (27) lose zwischen Deckel (22) und Wafer-oberseite liegt.

16. Vorrichtung nach einem der vorhergehenden Ansprüche, dadurch gekennzeichnet, daß im Grundkörper (23) ein Federkreuz (41) angeordnet ist, welches den Wafer (1) abstützt.

17. Vorrichtung nach Anspruch 16, dadurch gekennzeichnet, daß wenigstens eine der Zungen (42) des Federkreuzes (41) aus elektrisch leitfähigem Material besteht oder mit einem elektrisch leitfähigen Material ummantelt ist.

18. Vorrichtung nach Anspruch 16, dadurch gekennzeichnet, daß der Draht (10) zur elektrischen Kontaktierung des Wafers (1) mit der Zunge (42) des Federkreuzes (41) verbunden ist.

19. Vorrichtung nach Anspruch 16, dadurch gekennzeichnet, daß der Draht (10) und/oder die leitfähige Ummantelung (43) der Zunge (42) des Federkreuzes (41) aus Platin sind.

## Claims

1. Device for one-sided etching of a semiconductor wafer, of the type of an etching box, characterised by a trough-shaped basic body (3, 23), a lid (2, 22) which is matched to the basic body (3, 23) hermetically and has on the topside an opening (5, 25) for the passage of the etching liquid, at least two O-rings (7, 8, 27, 28), between which the wafer (1) to be etched is clamped, of which one (8, 28) is arranged concentrically in the basic body (3, 23) and the other (7, 27) concentrically in the lid (2, 22), and a bore (4) which extends through the basic body (3, 23) and connects the surface (14) of the basic body lying inside the O-ring (8, 28) to the outside of the basic body and through which a wire (10) connected to an electrical spring contact (11) for contacting the wafer is guided from the etching box.

2. Device according to Claim 1, characterised in that at least two O-rings (7, 8, 27, 28) have the same diameter.

3. Device according to Claim 1, characterised in that adjoining the outlet of the bore (4) is a small tube (6), a hose or the like which continues the bore and leads out of the etching solution.

4. Device according to Claim 3, characterised in that the small tube (6) or the hose are produced from polypropylene (PP) or polyvinylidene fluoride (PVDF) plastic.

5. Device according to Claim 1, characterised in that the lid (2) and basic body (3) are produced from PVDF plastic.

6. Device according to one of the preceding claims, characterised in that the inner region (12) of the underside of the lid is constructed elevated in the shape of a step and the inner region (13) of the topside of the basic body is constructed depressed in the shape of a step, and the steps have the same diameter.

7. Device according to one of the preceding claims, characterised in that the lid (2) and basic body (3) have grooves (17) and (18), respectively, in which the O-rings (7) and (8), respectively, are arranged protruding.

8. Device according to one of the preceding claims, characterised in that the basic body (3) has on the edge elevated with respect to the inner region (13) a further groove (19) in which a further O-ring (9) is arranged.

9. Device according to one of the preceding claims, characterised in that the lid (2) has in the edge depressed with respect to the inner region (12) a further groove in which a further O-ring (9) is arranged.

10. Device according to one of the preceding claims, characterised in that when the etching box is closed the edge regions of the lid (2) and of the basic body (3) lie flush against one another, with the exertion of a defined contact pressure on the O-rings (7, 8, 9) situated between the lid (2) and basic body (3).

11. Device according to Claim 1, characterised in that the spring contact (11) is constructed as a spring-loaded pin projecting from the bore (4).

12. Device according to one of the preceding claims, characterised in that the grooves (17) to (19) are configured such that they can absorb the volume of the O-rings (7) to (9) which is changed due to swelling and/or pressing, and the compressive forces transmitted via the O-rings (7) to (9) remain approximately constant.

13. Device according to Claim 1, characterised in that the lid (22) and basic body (23) of the etching box are produced from PP.

14. Device according to Claim 13, characterised in that the O-ring (28) lies loosely in the basic body (23).

15. Device according to Claim 13, characterised in that the O-ring (27) on the lid side lies loosely between the lid (22) and wafer topside.

16. Device according to one of the preceding claims, characterised in that a spring cross (41) which supports the wafer (1) is arranged in the basic body (23).

17. Device according to Claim 16, characterised in that at least one of the tongues (42) of the spring cross (41) consists of electrically conductive material or is sheathed in an electrically conductive material.

18. Device according to Claim 16, characterised in that the wire (10) for the electrical contacting of the wafer (1) is connected to the tongue (42) of the spring cross (41).

19. Device according to Claim 16, characterised in that the wire (10) and/or the conductive sheath (43) of the tongue (42) of the spring cross (41) are made from platinum.

## Revendications

1. Dispositif pour graver d'un côté une tranche semi-conductrice (tranche de silicium) du type boîte de gravure, dispositif caractérisé par un corps de base (3, 23) en forme de cuvette, par un couvercle (2, 22) s'adaptant de façon étanche au corps de base (3, 23) et qui présente du côté supérieur une ouverture (5, 25) servant au passage du liquide de gravure, par au moins deux joints toriques (7, 8, 27, 28) disposés l'un au-dessus de l'autre, entre lesquels est serrée la tranche de silicium à graver, dont l'un, le joint (8, 28), est disposé concentriquement au couvercle (2, 22) et par un perçage (4) s'étendant à travers le corps de base (3, 23) en reliant la surface du corps de base (14) se trouvant à l'intérieur du joint torique (8, 28) à la face extérieure du corps de base et à travers lequel on fait passer un fil (10) sortant à l'extérieur de la boîte de gravure qui est reliée par un contact électrique élastique (11) à la tranche de silicium pour la mise en contact avec celle-ci.

2. Dispositif selon la revendication 1, caractérisé en ce qu'au moins deux joints toriques (7, 8, 27, 28) ont le même diamètre.

3. Dispositif selon la revendication 1, caractérisé en ce qu'un petit tube (6), un tuyau ou une pièce analogue est raccordé à la sortie du perçage (4) et prolonge le perçage en sortant de la solution de gravure.

4. Dispositif selon la revendication 4, caractérisé en ce que le petit tube (6) ou le tuyau est fabriqué en polypropylène (PP) ou en fluorure de polyvinylidène (PVDF).

5. Dispositif selon la revendication 1, caractérisé en ce que le couvercle (2) et le corps de base (3) sont fabriqués en fluorure de polyvinylidène.

6. Dispositif selon l'une des revendications précédentes, caractérisé en ce que la zone intérieure (12) de la face intérieure du couvercle est surélevée en formant un gradin et la zone intérieure (13) de la face supérieure du corps de base est creusée en formant un gradin et en ce que les gradins possèdent le même diamètre.

7. Dispositif selon l'une des revendications précédentes, caractérisé en ce que le couvercle (2) et le corps de base (3) présentent des rainures (17) ou (18), dans lesquelles sont disposés en saillie les joints toriques (7) ou (8).

8. Dispositif selon l'une des revendications précédentes, caractérisé en ce que le corps de base (3) présente sur le bord surélevé par rapport à la zone intérieure (13) une autre rainure (19) dans laquelle est disposé un autre joint torique (9).

9. Dispositif selon l'une des revendications précédentes, caractérisé en ce que le couvercle (2) présente sur le bord abaissé par rapport à la zone intérieure (12) une autre rainure, dans laquelle est disposé un autre joint torique (9).

10. Dispositif selon l'une des revendications précédentes, caractérisé en ce que, quand la boîte de gravure est fermée, les zones des bords du couvercle (2) et du corps de base (3) reposent à ras l'une sur l'autre en exerçant une pression d'appui définie sur les joints toriques (7, 8, 9) se trouvant entre le couvercle (2) et le corps de base (3).

11. Dispositif selon la revendication 1, caractérisé en ce que le contact élastique (11) est constitué comme une tige élastique faisant saillie hors du perçage (4).

12. Dispositif selon l'une des revendications précédentes, caractérisé en ce que les rainures (17 à 19) ont une forme telle qu'elles peuvent recevoir le volume des joints toriques (7 à 9) modifié à la suite du gonflement et/ou de la compression et en ce que les forces de pression transmises par l'intermédiaire des joints toriques (7) à (9) demeurent à peu près constantes.

13. Dispositif selon la revendication 1, caractérisé en ce que le couvercle (22) et le corps de base (23) de la boîte de gravure sont fabriqués en polypropylène (PP).

14. Dispositif selon la revendication 13, caractérisé en ce que le joint torique (28) repose de façon lâche dans le corps de base (23).

15. Dispositif selon la revendication 13, caractérisé en ce que le joint torique (27) situé du côté du couvercle repose de façon lâche entre le couvercle (22) et la face supérieure de la tranche de silicium.

16. Dispositif selon l'une des revendications précédentes, caractérisé en ce que l'on dispose dans le corps de base (23) une croix élastique (41),qui s'appuie sur la tranche de silicium (1).

17. Dispositif selon la revendication 1, caractérisé en ce qu'au moins l'une des languettes (42) de la croix élastique (41) est en matière électriquement conductrice ou est enveloppée d'une matière électriquement conductrice.

18. Dispositif selon la revendication 16, caractérisé en ce que le fil (10) servant à la mise en contact électrique de la tranche de silicium (1) est relié à la languette (42) de la croix élastique (41).

19. Dispositif selon la revendication 16, caractérisé en ce que le fil (10) et/ou l'enveloppe conductrice (43) de la languette (42) de la croix élastique (41) sont en platine.
